**Europäisches Patentamt**

**European Patent Office**

**Office européen des brevets**

(19)

(11) Veröffentlichungsnummer: **0 215 197 B1**

(12)

# EUROPÄISCHE PATENTSCHRIFT

(45) Veröffentlichungstag der Patentschrift:
**27.12.90**

(51) Int. Cl.⁵: **H04N 5/14**, H03F 3/50

(21) Anmeldenummer: **86107556.2**

(22) Anmeldetag: **04.06.86**

(54) **Video-Endverstärker und zugehörige Stromversorgung.**

(30) Priorität: **23.08.85 DE 3530140**

(43) Veröffentlichungstag der Anmeldung:
**25.03.87 Patentblatt 87/13**

(45) Bekanntmachung des Hinweises auf die Patenterteilung:
**27.12.90 Patentblatt 90/52**

(84) Benannte Vertragsstaaten:
**AT CH DE LI**

(56) Entgegenhaltungen:
**EP-A- 0 030 191**
**EP-A- 0 163 235**
**DE-B- 1 167 900**
**US-A- 3 356 959**

(73) Patentinhaber: **GRUNDIG E.M.V. Elektro-Mechanische Versuchsanstalt Max Grundig holländ. Stiftung & Co. KG., Kurgartenstrasse 37, D-8510 Fürth/Bay.(DE)**

(72) Erfinder: **Hegenbart, Waldemar, Hinterm Rathaus 4, D-8621 Frohnlach(DE)**

## Beschreibung

Die Erfindung bezieht sich auf einen Video-Endverstärker mit Emitterausgang und zugehöriger Stromversorgung für die Ansteuerung von Leitungen gemäß dem Oberbegriff des Patentanspruchs 1.

Eine derartige Anordnung ist in der deutschen Auslegeschrift DE-B 1 167 900 beschrieben. Dort wird ein Transistorverstärker mit einer positiven und einer negativen Versorgungsspannung beschrieben, um durch die Emitter-Vorspannung den Transistor leitend zu machen, so daß bei einem Kurzschluß diese Vorspannung ausfällt und der Transistor sperrt. Der Arbeitspunkt wird dabei mit einem Widerstand zwischen Emitter und Spannungsversorgung festgelegt.

Zum Betrieb derartiger elektronischer Schalter benötigt man häufig ein positives und ein gleich großes negatives Betriebspotential. Diese lassen sich mit zwei gleichen Brückengleichrichterschaltungen erzeugen, wobei bei der einen Schaltung der Minuspol und bei der anderen der Pluspol geerdet ist. Darüber hinaus sind Schaltregler zur Erzeugung negativer Spannungen bei positiver Eingangsspannung bekannt (Lehrbuch "Halbleiter-Schaltungstechnik", Tietze/Schenk, 5. Auflage, 1980, Seite 391, 395).

Üblicherweise werden auch die Plus/Minus/ Masse-Spannungen in einem Netzteil erzeugt und in die signalverarbeitenden Schaltungsteile, meist in Form von Leiterplatten, eingespeist. Das Stromversorgungsgerät und die Verdrahtung wird dadurch allerdings aufwendig und unkomfortabel und kommt Standardisierungsbemühungen - eine Versorgungsspannung für verschiedene Geräte - nicht entgegen. Außerdem sind bei derartigen herkömmlichen Schaltungsausführungen hohe Verlustleistungen gegeben.

Der Erfindung liegt daher die Aufgabe zugrunde, einen Video-Endverstärker der eingangs genannten Art zu schaffen, der einen einfachen Schaltungsaufbau bei zusätzlicher Verlustleistungsreduzierung gestattet.

Diese Aufgabe wird erfindungsgemäß durch die im kennzeichnenden Teil des Patentanspruchs 1 angegebenen Maßnahmen gelöst.

Weitere Ausgestaltungen der erfindungsgemäßen Schaltungsanordnung ergeben sich aus den Unteransprüchen.

Mit dem erfindungsgemäßen Video-Endverstärker für die Ansteuerung von Leitungen ist es möglich, bei nur einer primären Versorgungsspannung die erforderlichen Betriebsspannungen durch einen Schaltregler mit sehr geringem Aufwand auf einer signalverarbeitenden Leiterplatte zu realisieren, was einen hohen Wirkungsgrad bewirkt. Auch läßt sich dadurch eine Verlustleistungsreduzierung ohne zusätzliche Belastung des Netzteils erzielen.

Die Erfindung wird im folgenden unter Bezugnahme auf die Zeichnungsfiguren beispielsweise näher erläutert. Es zeigen

Fig. 1 Schaltbilder zur Erläuterung des Anwendungsprinzips eines Video-Endverstärkers und

Fig. 2 eine Anordnung zur Stromversorgung eines Videoverstärkers gemäß der Erfindung.

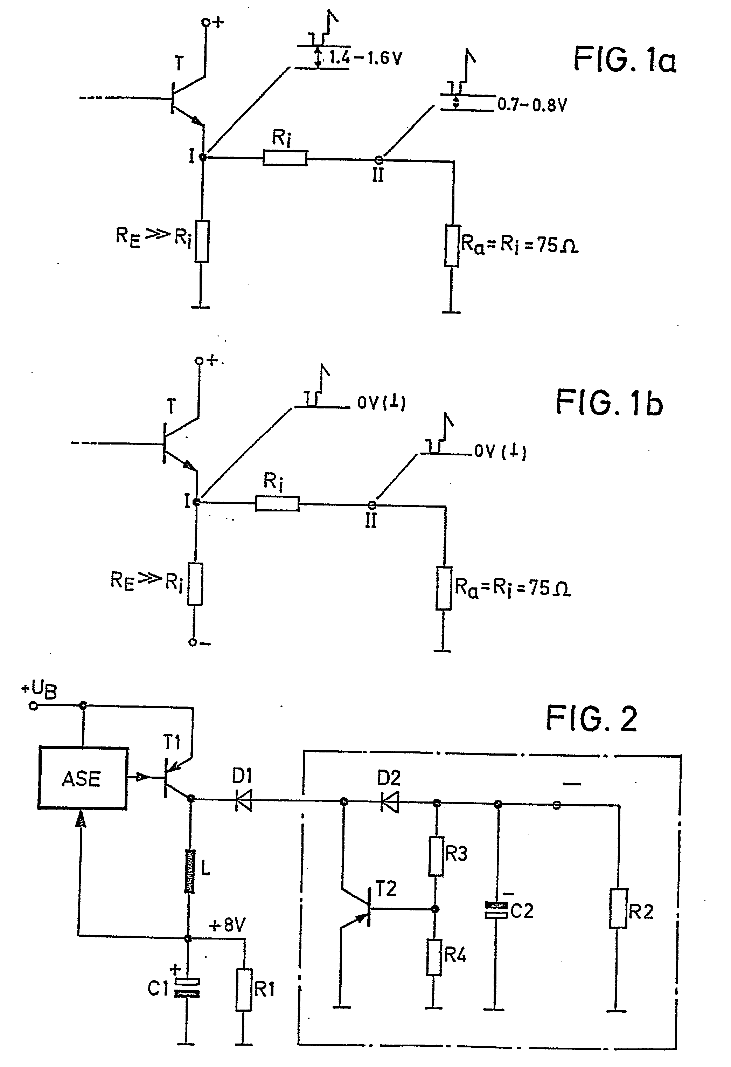

Mit den Fig. 1a und 1b wird näher dargelegt, wie der erfindungsgemäße Video-Endverstärker prinzipiell bei einer Videosignalverteilung zur Ansteuerung der Leitungen eingesetzt wird.

Fig. 1a gibt an, daß gleichspannungsgekoppelte Video-Signalausgänge aus Linearitätsgründen eine Gleichspannungs-Abhebung für die Synchronspitze von mindestens 1,4 ... 1,6 V benötigen, wenn sie aus einer einfachen Plus/Masse-Quelle gespeist werden. Diese Gleichspannungs-Abhebung ist in Fig. 1a durch das Spannungsdiagramm am Punkt I am Emitter des Transistors T dargestellt, dessen Kollektor mit Pluspotential verbunden ist. Sind Innenwiderstand $R_i$ und Abschlußwiderstand $R_a$ gleich groß und betragen 75 Ohm ($R_i = R_a = 75$ Ohm), fließt ein signalunabhängiger Mindeststrom von ca. 10 mA. Der signalabhängige Strom ist bei der dem Austastpegel zugeordneten Spannung $U_{aus} = 1$ Vss etwa 13 mA. Beispielsweise bei der Verteilung von Videosignalen, d.h. bei sogenannten Videoverteilerverstärkern mit bis zu zehn Ausgängen, entsteht deswegen eine beträchtliche unerwünschte Belastung des Netzteils.

Bei Verwendung einer Plus/Minus/Masse-Versorgung kann der signallose Verstärkerausgang, ebenso wie der aus der Summe von Innenwiderstand $R_i$ und Abschlußwiderstand $R_a$ ($R_i + R_a$) gebildete Lastwiderstand an 0 V liegen - der signalunabhängige Gleichstrom im Zweig durch $R_i$ und $R_a$ wird nahezu 0 mA, was mit Fig. 1b näher dargestellt ist, die sich von Fig. 1a neben den anderen Signalverläufen an den Punkten I und II noch dadurch von Fig. 1a unterscheidet, daß der Emitterwiderstand $R_E$ nicht an Masse (wie der Abschlußwiderstand $R_a$ oder wie in Fig. 1a), sondern an Minuspotential gelegt ist.

Mit dieser Maßnahme (Emitterwiderstand an Minuspotential) und ferner durch geeignete Wahl des Stromes durch den Emitterwiderstand $R_E$ lassen sich lineare Bedingungen erreichen. D. h., der Arbeitspunkt des Video-Endverstärkers wird mit Hilfe des Emitterwiderstandes und der negativen Versorgungsspannung so eingestellt, daß die Spannung am Emitter gegen Masse bei fehlendem Videosignal Null wird und gleichzeitig durch den Video-Endverstärker ein solcher Strom fließt, daß eine lineare Arbeitskennlinie bei Aussteuerung mit dem Videosignal gewährleistet ist.

Ein praktisches Ausführungsbeispiel zur Stromversorgung eines Video-Endverstärkers gemäß der Erfindung unter Verwendung eines einzigen Schaltreglers ist in Fig. 2 näher dargestellt. Die geeignete Betriebsspannung wird demnach durch einen Schaltregler mit äußerst geringem Schaltungsaufwand auf der signalverarbeitenden Leiterplatte erzeugt, wobei durch die zusätzlich erzeugte negative Spannung die vorstehend beschriebene zusätzliche Verlustleistungsreduzierung erzielt wird.

Gemäß Fig. 2 gewinnt ein herkömmlicher Schaltregler aus einer Eingangsspannung von beispielsweise 20 ... 35 V zunächst eine Spannung von + 8 V. Der Schaltregler besteht dabei aus einer Ansteuereinheit ASE, deren Ausgang mit der Basis eines Transistors T1 verbunden ist. Der Emitter des Transistors T1 ist mit dem Pluspotential der Eingangsspannung $U_B$ verbunden, während der Kollektor des Transistors T1 zum einen mit dem einen Anschluß einer Spule L und zum anderen mit der Kathode einer Diode D1 verbunden ist. Der andere Anschluß der Spule L ist mit dem Eingang der Ansteuereinheit ASE sowie einem Siebkondensator C1 und einem Lastwiderstand R1 verbunden, wobei Siebkondensator und Lastwiderstand an Masse gelegt sind.

Der Schaltregler arbeitet bekanntlich so, daß der Leistungsschalter (Transistor T1) einschaltet, wenn die Ausgangsspannung den Sollwert unterschreitet. Dadurch fließt ein linear ansteigender Strom über die Spule L (Speicherdrossel) in die Last (Lastwiderstand R1), und die Ausgangsspannung steigt. Beim Erreichen des Sollwerts schaltet der Transistor T1 wieder ab. Jetzt erzwingt die vorher in der Spule L gespeicherte Energie einen linear abfallenden Strom über die Diode D1 im Lastwiderstand R1.

Erfindungsgemäß wird der Video-Endverstärker mit Emitterausgang mit einer gegen Masse positiven und einer gegen Masse negativen Spannung gespeist, während der Arbeitspunkt des Video-Endverstärkers mit Hilfe eines Widerstandes zwischen Emitter und der negativen Versorgungsspannung so eingestellt wird, daß die Spannung am Emitter bei fehlendem Videosignal zu Null wird und gleichzeitig durch den Video-Endverstärker ein solcher Strom fließt, daß eine lineare Arbeitskennlinie bei Aussteuerung mit dem Videosignal gewährleistet ist. Zudem werden die positive und negative Speisespannung des Video-Endverstärkers in einem einzigen Schaltregler erzeugt, wobei die gegenüber der ersten Ausgangsspannung des Schaltreglers gegen Masse umgekehrt gepolte zweite Versorgungsspannung durch die Einfügung einer spannungsstabilisierenden Schaltung in die Verbindung zwischen der Energie-Rückgewinnungs-Diode und Masse gewonnen wird.

Wird anodenseitig an die Diode D1 ein an Masse gelegter Lastwiderstand R2 in Serie geschaltet, so steht an diesem eine gegen Masse ungeregelte negative Spannung an. Zur Stabilisierung der an der Last, das heißt dem Lastwiderstand R2, anliegenden negativen Spannung kann eine spannungsstabilisierende Schaltung (Parallelregler) vorgesehen werden, die im einfachsten Fall aus einer Z-Diode besteht.

In Fig. 2 ist die spannungsstabilisierende Schaltung ein Transistorregelverstärker, der eine Wirkungsgradverschlechterung einer Z-Dioden-Stabilisierung verhindert. Der Transistorregelverstärker besteht dabei aus einem Transistor T2, dessen Kollektor mit der Anode der Diode D1 sowie der Kathode einer weiteren Diode D2 verbunden ist. Der Emitter des Transistors T2 ist an Masse geführt, während an der Basis ein Spannungsteiler (Widerstände R3 und R4) angeschlossen ist. Mit der Anode der Diode D2 verbunden ist neben dem einen Anschluß des Spannungsteilerwiderstandes R3 der eine Anschluß eines an Masse gelegten zweiten Kondensators C2 sowie der ebenfalls an Masse gelegte Lastwiderstand R2. Der Widerstand R3 gemäß Fig. 2 kann in bekannter Weise wahlweise durch eine Z-Diode ersetzt sein.

Die in Figur 1b dargestellte positive und negative Versorgungsspannung, die mit "+" und "–" gekennzeichnet ist, wird am Widerstand R1 (+8V) und am Widerstand R2 (–) der Figur 2 abgegriffen.

## Patentansprüche

1. Video-Endverstärker mit Emitterausgang und zugehöriger Stromversorgung für die Ansteuerung von Leitungen, bei der die Anpassung des Generator-Innenwiderstandes (Ri) an den Wellenwiderstand (Ra) der Leitung durch die Einfügung eines Widerstandes ($R_E$) am Emitterausgang erreicht wird der Video-Endverstärker (T, Ri, $R_E$) mit Emitterausgang mit einer gegen Masse positiven (+) und einer gegen Masse negativen (–) Spannung gespeist wird, dadurch gekennzeichnet, daß

– der Arbeitspunkt des Video-Endverstärkers (T, Ri, $R_E$) mit Hilfe des Widerstandes ($R_E$) zwischen Emitter und der negativen Versorgungsspannung (–) so eingestellt wird, daß die Spannung am Emitter gegen Masse bei fehlendem Videosignal zu Null wird und gleichzeitig durch den Video-Endverstärker (T, Ri, $R_E$) ein solcher Strom fließt, daß eine lineare Arbeitskennlinie bei Aussteuerung mit dem Videosignal gewährleistet ist,

– die positive (+) und negative (–) Speisespannung des Video-Endverstärkers (T, Ri, $R_E$) in einem einzigen Schaltregler (ASE, T1, L, D1, R1, T2, R3, R4, D2, C2) erzeugt wird, wobei die gegenüber der ersten Ausgangsspannung (+8V) des Schaltreglers gegen Masse umgekehrt gepolte zweite Versorgungsspannung (–) durch die Einfügung einer spannungsstabilisierenden Schaltung (T2, R3, R4, D2, C2) in die Verbindung zwischen der Energie-Rückgewinnungs-Diode (D1) und Masse gewonnen wird.

2. Video-Endverstärker nach Anspruch 1, dadurch gekennzeichnet, daß die spannungsstabilisierende Schaltung eine Z-Diode ist.

3. Video-Endverstärker nach Anspruch 1, dadurch gekennzeichnet, daß die spannungsstabilisierende Schaltung ein Transistorregelverstärker (T2, R3, R4, D2, C2) ist.

## Claims

1. Video output amplifier with emitter output and associated power supply for driving lines, in which the internal resistance (Ri) of the generator is matched to the characteristic impedance (Ra) of the line by inserting a resistor ($R_E$) at the emitter output and the video output amplifier (T, Ri, $R_E$) with emitter output is fed with a voltage which is positive (+) with respect to earth and with a voltage which is negative (-) with respect to earth, characterized in that

- the operating point of the video output amplifier

(T, Ri, RE) is set with the aid of the resistor (RE) between emitter and the negative supply voltage (-) in such a manner that the voltage at the emitter with respect to earth becomes zero when there is no video signal and, at the same time, such a current flows through the video output amplifier (T, Ri, RE) that a linear operating characteristic is ensured when it is driven with the video signal,

- the positive (+) and negative (-) feed voltage of the video output amplifier (T, Ri, RE) is generated in a single switched-mode regulator (ASE, T1, L, D1, L1, R1, T2, R3, R4, D2, C2), the second supply voltage (-), which is reversely polarized with respect to earth compared with the first output voltage (+8V) of the switched-mode regulator, being obtained by the insertion of a voltage-stabilizing circuit (T2, R3, R4, D2, C2) into the connection between the energy recovery diode (D1) and earth.

2. Video output amplifier according to Claim 1, characterized in that the voltage-stabilizing circuit is a Z diode.

3. Video output amplifier according to Claim 1, characterized in that the voltage-stabilizing circuit is a transistor control amplifier (T2, R3, R4, D2, C2).

**Revendications**

1. Amplificateur vidéo de sortie à sortie sur l'émetteur et alimentation correspondante, destiné à la commande de lignes, dans lequel l'adaptation de la résistance interne du générateur (ai) à la résistance caractéristique (Ra) de la ligne est obtenue par l'introduction d'une résistance (RE) sur la sortie de l'émetteur et dans lequel l'amplificateur vidéo de sortie (T, Ri, RE) à sortie sur l'émetteur est alimenté avec une tension positive (+) par rapport à la masse et une tension négative (-) par rapport à la masse, caractérisé en ce que :

- le point de fonctionnement de l'amplificateur vidéo de sortie (T, Ri, RE) est réglé au moyen de la résistance (RE) disposée entre l'émetteur et la tension négative (-) d'alimentation de telle manière que la tension sur l'émetteur par rapport à la masse s'annule lorsque le signal vidéo est absent et que, simultanément, il circule à travers l'amplificateur vidéo de sortie (T, Ri, RE) un courant tel qu'on obtient une caractéristique de travail linéaire pour un réglage maximal avec le signal vidéo ;
- les tensions positive ("+") et négative ("-") d'alimentation de l'amplificateur vidéo de sortie (T, Ri, RE) sont produites dans un régulateur de commutation unique (ASE, T1, L, D1, L1, R1, T2, R3, R4, D2, C2), la deuxième tension d'alimentation (-) qui présente une polarité inversée par rapport à la masse par comparaison avec la première tension de sortie (+8V) du régulateur de commutation étant obtenue par l'introduction d'un circuit stabilisateur de tension (T2, R3, R4, D2, C2) dans la liaison entre la diode (131) de récupération d'énergie et la masse.

2. Amplificateur vidéo de sortie selon la revendication 1, caractérisé en ce que le circuit stabilisateur de tension est une diode Zener.

3. Amplificateur vidéo de sortie selon la revendication 1, caractérisé en ce que le circuit stabilisateur de tension est un amplificateur de réglage à transistor (T2, R3, R4, D2, C2).

# FIG. 1a

$1.4 - 1.6\,V$

$0.7 - 0.8\,V$

T

I

$R_i$

II

$R_E \gg R_i$

$R_a = R_i = 75\,\Omega$

# FIG. 1b

$0V(\bot)$

$0V(\bot)$

T

I

$R_i$

II

$R_E \gg R_i$

$R_a = R_i = 75\,\Omega$

# FIG. 2

$+U_B$

ASE

T1

D1

D2

—

L

T2

R3

C2

R2

$+8V$

R4

C1

R1